# EUROPEAN PATENT APPLICATION

(11) **EP 4 778 881 A1**
(43) Date of publication of application: **22.07.2026**
(21) Application number: 26151405.3
(22) Date of filing: 12.01.2026
(51) Int. Cl.: B81B 3/00, G01C 19/5712, G01P 15/125, G01C 19/5684

(54) **SENSOR AND ELECTRONIC DEVICE**

(30) Priority: 15.01.2025 JP 2025005677
(71) Applicant: KABUSHIKI KAISHA TOSHIBA, Kawasaki-shi, Kanagawa 212-0013 (JP)
(72) Inventor: MURASE, Hideaki, Kawasaki-shi 212-0013 (JP); ONO, Daiki, Kawasaki-shi 212-0013 (JP); MIYAZAKI, Fumito, Kawasaki-shi 212-0013 (JP); TOMIZAWA, Yasushi, Kawasaki-shi 212-0013 (JP)
(74) Representative: Marks & Clerk LLP

(57) **Abstract**

According to one embodiment, a sensor includes an element portion. The element portion includes a base including a base face, a fixed portion fixed to the base face, a movable portion supported by the fixed portion, first to fourth electrodes A gap is provided between the base face and the movable portion. The movable portion includes a first annular portion provided around the fixed portion in a first plane along the base face. The first annular portion includes first to fourth partial regions. The first electrode is fixed to the base face and faces the first partial region. The second electrode is fixed to the base face and faces the second partial region. The third electrode is fixed to the base face and faces the third partial region. The fourth electrode is fixed to the base face and faces the fourth partial region.

## Description

### FIELD

Embodiments described herein relate generally to a sensor and an electronic device.

### BACKGROUND

For example, there is a sensor using a MEMS (Micro Electro Mechanical Systems) element, etc. In the sensors, improvement of characteristics such as broadband is desired.

### BRIEF DESCRIPTION OF THE DRAWINGS

FIGS. 1A and 1B are schematic views illustrating a sensor according to a first embodiment;
FIGS. 2A and 2B are schematic diagrams illustrating the operation of the sensor according to the first embodiment;
FIGS. 3A and 3B are schematic diagrams illustrating the operation of a sensor according to a first reference example;
FIGS. 4A and 4B are schematic diagrams illustrating the operation of a sensor according to a second reference example;
FIS. 5A to 5C are graphs illustrating the characteristics of the sensors;
FIG. 6 is a schematic plan view illustrating a sensor according to the first embodiment;
FIG. 7 is a schematic diagram illustrating an electronic device according to a second embodiment;
FIGS. 8A to 8G are schematic diagrams illustrating applications of the electronic device according to the embodiment; and
FIGS. 9A and 9B are schematic diagrams illustrating applications of the sensor according to the embodiment.

### DETAILED DESCRIPTION

According to one embodiment, a sensor includes an element portion. The element portion includes a base including a base face, a fixed portion fixed to the base face, a movable portion supported by the fixed portion, a first electrode, a second electrode, a third electrode, and a fourth electrode. A gap is provided between the base face and the movable portion. The movable portion includes a first annular portion provided around the fixed portion in a first plane along the base face. The first annular portion includes a first partial region, a second partial region, a third partial region, and a fourth partial region. The first electrode is fixed to the base face and faces the first partial region. The second electrode is fixed to the base face and faces the second partial region. The third electrode is fixed to the base face and faces the third partial region. The fourth electrode is fixed to the base face and faces the fourth partial region. A first direction from the first electrode to the second electrode crosses a second direction from the third electrode to the fourth electrode. The first partial region is between the first electrode and the fixed portion in the first direction. The second partial region is between the fixed portion and the second electrode in the first direction. The third electrode is between the third partial region and the fixed portion in the second direction. The fourth electrode is between the fixed portion and the fourth partial region in the second direction. The first electrode, the second electrode, the third electrode, and the fourth electrode are configured to be input with a first signal.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### (First Embodiment)

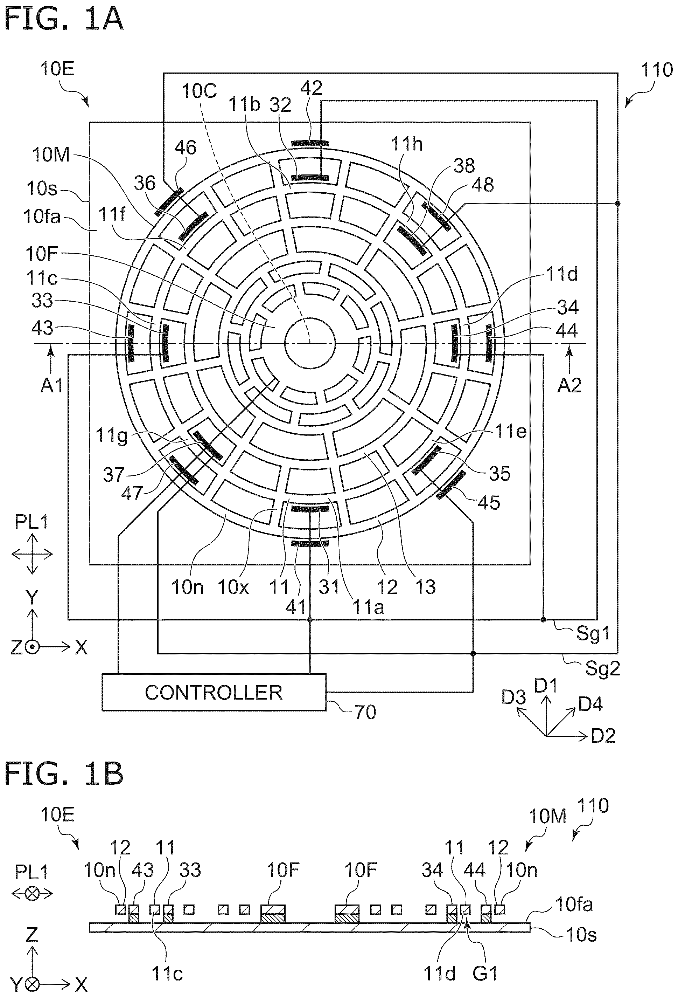

FIGS. 1A and 1B are schematic views illustrating a sensor according to a first embodiment.

FIG. 1A is a plan view. FIG. 1B is a cross-sectional view taken along the line A1-A2 in FIG. 1A.

As shown in FIGS. 1A and 1B, a sensor 110 according to the embodiment includes an element portion 10E. The sensor 110 may further include a controller 70.

The element portion 10E includes a base 10s, a fixed portion 10F, a movable portion 10M, a first electrode 31, a second electrode 32, a third electrode 33, and a fourth electrode 34.

The base 10s includes a base face 10fa. The fixed portion 10F is fixed to the base face 10fa. The movable portion 10M is supported by the fixed portion 10F. A gap G1 is provided between the base face 10fa and the movable portion 10M.

The base face 10fa is along a first plane PL1. One direction along the first plane PL1 is defined as an X-axis direction. A direction along the first plane PL1 and perpendicular to the X-axis direction is defined as a Y-axis direction. A direction perpendicular to the X-axis direction and the Y-axis direction is defined as a Z-axis direction.

The movable portion 10M includes, for example, a first annular portion 11. The first annular portion 11 is provided around the fixed portion 10F on the first plane PL1 along the base face 10fa.

In this example, the movable portion 10M includes a plurality of annular portions 10n. The plurality of annular portions 10n are provided around the fixed portion 10F on the first plane PL1. The plurality of annular portions 10n are concentric around the fixed portion center 10C on the first plane PL1 of the fixed portion 10F. The movable portion 10M may include a radiating portion 10x. The radiating portion 10x is connected to the fixed portion 10F. The radiating portion 10x extends along a radiating direction. The radiating direction is a direction that passes through the fixed portion center 10C and is along the base face 10fa. The plurality of annular portions 10n (such as the first annular portion 11) are connected to the radiating portion 10x.

In this example, the plurality of annular portions 10n include the first annular portion 11, a second annular portion 12, and a third annular portion 13, etc. In this example, the first annular portion 11 is between the fixed portion 10F and the other annular portions 10n. The position (order) of the first annular portion 11 in the plurality of annular portions 10n may be arbitrary.

The first annular portion 11 may include plurality of partial regions. For example, the first annular portion 11 may include a first partial region 11a, a second partial region 11b, a third partial region 11c, and a fourth partial region 11d, etc.

The first electrode 31 is fixed to the base face 10fa and faces the first partial region 11a. The second electrode 32 is fixed to the base face 10fa and faces the second partial region 11b. The third electrode 33 is fixed to the base face 10fa and faces the third partial region 11c. The fourth electrode 34 is fixed to the base face 10fa and faces the fourth partial region 11d.

A first direction D1 from the first electrode 31 to the second electrode 32 crosses a second direction D2 from the third electrode 33 to the fourth electrode 34. In this example, an angle between the first direction D1 and the second direction D2 (first angle) is substantially 90 degrees. The first angle may be, for example, not less than 85 degrees and not more than 95 degrees.

As shown in FIG. 1A, the first partial region 11a is between the first electrode 31 and the fixed portion 10F in the first direction D1. The second partial region 11b is between the fixed portion 10F and the second electrode 32 in the first direction D1. The third electrode 33 is between the third partial region 11c and the fixed portion 10F in the second direction D2. The fourth electrode 34 is between the fixed portion 10F and the fourth partial region 11d in the second direction D2.

For example, the first electrode 31 and the second electrode 32 are on the outside of the first annular portion 11. The third electrode 33 and the fourth electrode 34 are on the inside of the first annular portion 11.

The first electrode 31, the second electrode 32, the third electrode 33, and the fourth electrode 34 are configures to be input with the same signal (e.g., a first signal). For example, the first electrode 31, the second electrode 32, the third electrode 33, and the fourth electrode 34 may be electrically connected to each other.

The above signal may be supplied from the controller 70. The controller 70 may be included in the sensor 110. The controller 70 may be provided separately from the sensor 110. In a first operation, the controller 70 is configured to apply a first signal (e.g., a first AC signal Sg1) between the first electrode 31 and the movable portion 10M, between the second electrode 32 and the movable portion 10M, between the third electrode 33 and the movable portion 10M, and between the fourth electrode 34 and the movable portion 10M. The first electrode 31, the second electrode 32, the third electrode 33, and the fourth electrode 34 are, for example, driving electrodes.

The first AC signal Sg1 causes deformation (e.g., vibration) in the movable portion 10M. As described above, the first electrode 31 and the second electrode 32 are located outside the first annular portion 11. The third electrode 33 and the fourth electrode 34 are located inside the first annular portion 11. By supplying the first AC signal Sg1 to these electrodes, the vibration mode at high frequencies in the vibration of the movable portion 10M is suppressed with a simple configuration. By suppressing the vibration mode at high frequencies, stable detection can be performed with high accuracy over a wide band. For example, a sensor capable of wideband can be provided. According to the embodiment, a sensor capable of improving characteristics can be provided.

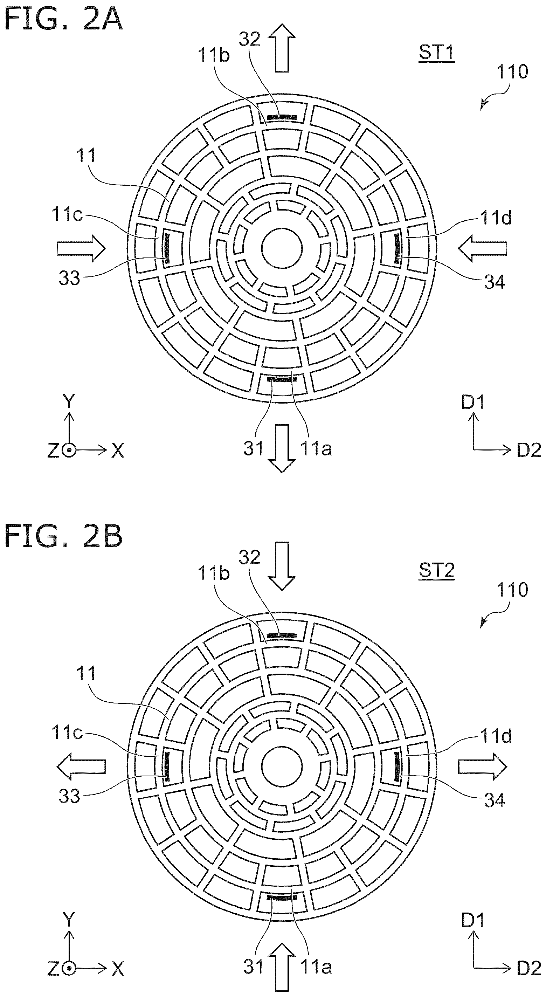

FIGS. 2A and 2B are schematic diagrams illustrating the operation of the sensor according to the first embodiment.

These diagrams illustrate the force applied to the movable portion 10M in the first operation in which the first AC signal Sg1 is applied to the electrodes. In a first state ST1 illustrated in FIG. 2A, the movable portion 10M deforms such that the first partial region 11a and the second partial region 11b expand outward. At this time, the movable portion 10M deforms such that the third partial region 11c and the fourth partial region 11d shrink inward.

In a second state ST2 illustrated in FIG. 2B, the movable portion 10M deforms such that the first partial region 11a and the second partial region 11b shrink inward. At this time, the movable portion 10M deforms such that the third partial region 11c and the fourth partial region 11d expand outward.

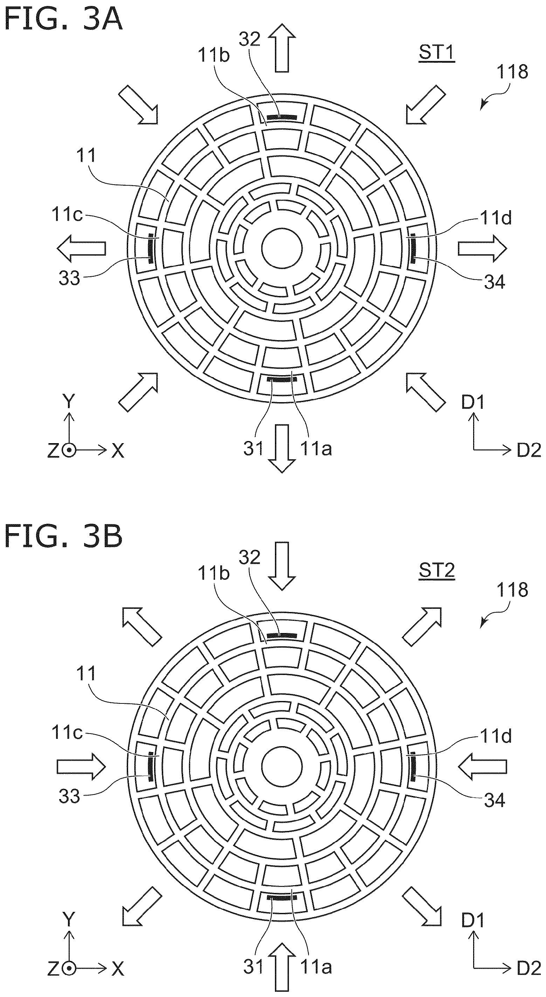

FIGS. 3A and 3B are schematic diagrams illustrating the operation of a sensor according to a first reference example.

These figures illustrate the operation of a sensor 118 according to a first reference example. In the sensor 118, the first electrode 31, the second electrode 32, the third electrode 33, and the fourth electrode 34 are located outside the first annular portion 11. A first alternating current is applied to these four electrodes. In the first state ST1 illustrated in FIG. 3A, the movable portion 10M deforms so that the first partial region 11a, the second partial region 11b, the third partial region 11c, and the fourth partial region 11d expand outward. At this time, in the direction between these electrodes (diagonal direction in the figure), the movable portion 10M deforms so as to shrink inward.

In the second state ST2 illustrated in FIG. 3B, the movable portion 10M deforms such that the first partial region 11a, the second partial region 11b, the third partial region 11c, and the fourth partial region 11d shrink inward. At this time, the movable portion 10M deforms such that it expands outward in the direction between these electrodes (diagonal direction in the figure). The sensor 118 has a vibration mode with a higher frequency than sensor 110.

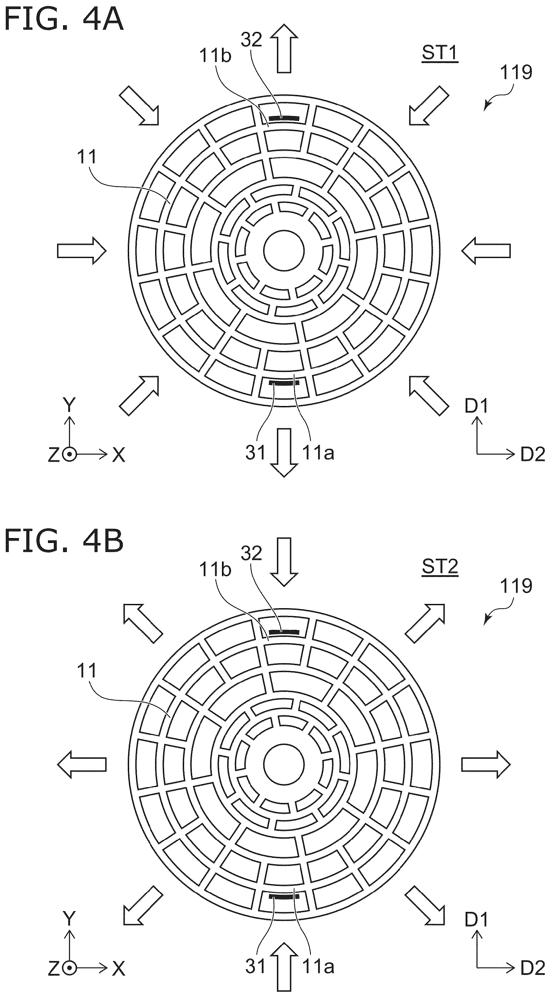

FIGS. 4A and 4B are schematic diagrams illustrating the operation of a sensor according to a second reference example.

These diagrams illustrate the operation of a sensor 119 according to a second reference example. In the sensor 119, the first electrode 31 and the second electrode 32 are provided, and the third electrode 33 and the fourth electrode 34 are not provided. The first electrode 31 and the second electrode 32 are located outside the first annular portion 11. A first alternating current is applied to the first electrode 31 and the second electrode 32. In the first state ST1 illustrated in FIG. 4A, the movable portion 10M deforms so that the first partial region 11a and the second partial region 11b expand outward. At this time, in a direction different from these electrodes (including a diagonal direction in the figure), the movable portion 10M deforms so as to shrink inward.

In the second state ST2 illustrated in FIG. 4B, the movable portion 10M deforms such that the first partial region 11a and the second partial region 11b shrink inward. At this time, the movable portion 10M deforms such that it expands outward in a direction different from these electrodes (including diagonal directions in the figure). The sensor 119 has a vibration mode with a higher frequency than sensor 110.

FIS. 5A to 5C are graphs illustrating the characteristics of the sensors.

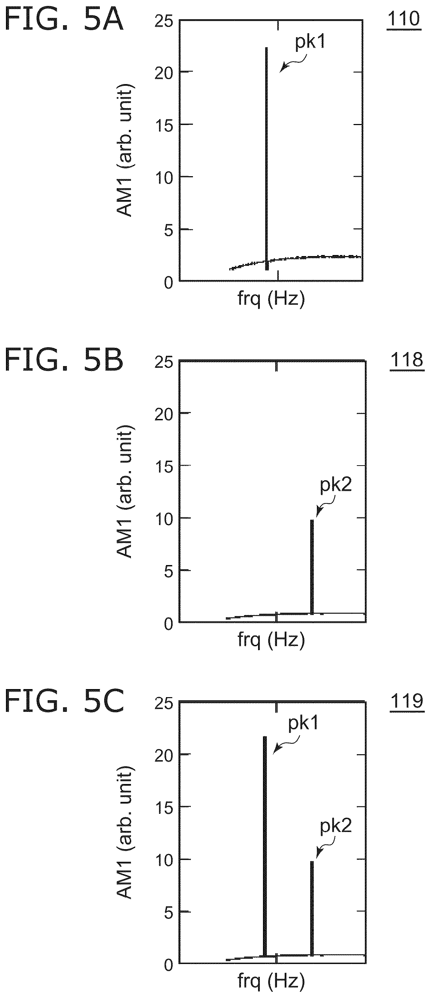

FIG. 5A corresponds to the sensor 110 according to the embodiment. FIG. 5B corresponds to the sensor 118 of the first reference example. FIG. 5C corresponds to the sensor 119 of the second reference example. These figures illustrate the vibration characteristics of the movable portion 10M. The horizontal axis is the frequency frq. The vertical axis is the vibration amplitude AM1. As shown in FIG. 5A, one peak (first peak pk1) is generated in the sensor 110. The frequency of the first peak pk1 corresponds to the frequency of the first AC signal Sg1.

As shown in FIG. 5B, a second peak pk2 is generated in the sensor 118. The frequency of the second peak pk2 is higher than the frequency of the first peak pk1. The second peak pk2 is a high-frequency peak.

As shown in FIG. 5C, in the sensor 119, in addition to the first peak pk1, the second peak pk2 occurs. Thus, in the sensor 119, a vibration mode at high frequencies occurs. In contrast, in the sensor 110, the vibration mode at high frequencies is suppressed. This enables detection operation over a wide band.

As shown in FIG. 2A and FIG. 2B, in the embodiment, when the distance (first distance) between first partial region 11a and second partial region 11b increases, the distance (second distance) between third partial region 11c and fourth partial region 11d decreases. When the first distance decreases, the second distance increases. In the embodiment, the vibration mode at high frequencies is suppressed by a simple configuration.

The vibration state of the first annular portion 11 (movable portion 10M) changes, for example, depending on the angular velocity applied to the element portion 10E. For example, the angular velocity can be detected by detecting the change in the vibration state of the first annular portion 11. The change in the vibration state depending on the angular velocity may be based on the Coriolis force, for example.

In the embodiment, the change in the vibration state of the first annular portion 11 (movable portion 10M) may be detected, for example, by detecting a change in at least one of the optical characteristics, magnetic characteristics, and electrical characteristics. For example, the vibration state of the first annular portion 11 (movable portion 10M) may be detected by detecting a change in the state of reflected light at the movable portion 10M.

Below, an example will be described in which a change in the vibration state of the first annular portion 11 (movable portion 10M) is detected by the detection electrodes.

As shown in FIG. 1A, the element portion 10E may include a first detection electrode 41, a second detection electrode 42, a third detection electrode 43, and a fourth detection electrode 44. The first detection electrode 41 is fixed to the base face 10fa and faces the movable portion 10M. The second detection electrode 42 is fixed to the base face 10fa and faces the movable portion 10M. The third detection electrode 43 is fixed to the base face 10fa and faces the movable portion 10M. The fourth detection electrode 44 is fixed to the base face 10fa and faces the movable portion 10M.

A direction from the first detection electrode 41 to the second detection electrode 42 (first detection direction) crosses a direction from the third detection electrode 43 to the fourth detection electrode 44 (second detection direction). For example, the first detection direction may be along the first direction D1. The second detection direction may be along the second direction D2.

The vibration of the movable portion 10M generates electrical signals in these detection electrodes. The electrical signals correspond to changes in the electrostatic capacitance between the movable portion 10M and these detection electrodes. The electrical signals may be detected by the controller 70.

The controller 70 may be configured to detect the angular velocity acting on the element portion 10E based on information including, for example, a first detection signal obtained between the first detection electrode 41 and the movable portion 10M, a second detection signal obtained between the second detection electrode 42 and the movable portion 10M, a third detection signal obtained between the third detection electrode 43 and the movable portion 10M, and a fourth detection signal obtained between the fourth detection electrode 44 and the movable portion 10M.

In this example, the movable portion 10M further includes the second annular portion 12. The second annular portion 12 is concentric with the first annular portion 11, centered on the fixed portion center 10C on the first plane PL1 of the fixed portion 10F. The second annular portion 12 may be on the outside or inside of the first annular portion 11. In this example, the first annular portion 11 is between the fixed portion 10F and the second annular portion 12. In this example, the first detection electrode 41, the second detection electrode 42, the third detection electrode 43, and the fourth detection electrode 44 face the second annular portion 12. The annular portion 10n to which these electrodes face may be considered as the second annular portion 12.

As shown in FIG. 1A, the first annular portion 11 may include a fifth partial region 11e, a sixth partial region 11f, a seventh partial region 11g, and an eighth partial region 11h. The element portion 10E may include a fifth electrode 35, a sixth electrode 36, a seventh electrode 37, and an eighth electrode 38. The fifth electrode 35 is fixed to the base face 10fa and faces the fifth partial region 11e. The sixth electrode 36 is fixed to the base face 10fa and faces the sixth partial region 11f. The seventh electrode 37 is fixed to the base face 10fa and faces the seventh partial region 11g. The eighth electrode 38 is fixed to the base face 10fa and faces the eighth partial region 11h.

A third direction D3 from the fifth electrode 35 to the sixth electrode 36 crosses a fourth direction D4 from the seventh electrode 37 to the eighth electrode 38. The third direction D3 is inclined with respect to the first direction D1.

The fifth partial region 11e is between the fifth electrode 35 and the fixed portion 10F in the third direction D3. The sixth partial region 11f is between the fixed portion 10F and the sixth electrode 36 in the third direction D3. The seventh electrode 37 is between the seventh partial region 11g and the fixed portion 10F in the fourth direction D4. The eighth electrode 38 is between the fixed portion 10F and the eighth partial region 11h in the fourth direction D4.

For example, the fifth electrode 35 and the sixth electrode 36 are on the outside of the first annular portion 11. The seventh electrode 37 and the eighth electrode 38 are on the inside of the first annular portion 11.

The fifth electrode 35, the sixth electrode 36, the seventh electrode 37, and the eighth electrode 38 are configured to be input with the same signal (second signal). The fifth electrode 35, the sixth electrode 36, the seventh electrode 37, and the eighth electrode 38 are, for example, electrically connected.

The fifth electrode 35, the sixth electrode 36, the seventh electrode 37, and the eighth electrode 38 provide vibrations in a direction different from the vibrations provided by the first electrode 31, the second electrode 32, the third electrode 33, and the fourth electrode 34. Information regarding angular velocity may be obtained by the vibrations in two different directions.

For example, an angle (second angle) between the third direction D3 and the fourth direction D4 may be substantially 90 degrees. The second angle may be, for example, not less than 85 degrees and not more than 95 degrees.

For example, an angle between the third direction D3 and the first direction D1 may be substantially 45 degrees. The rotation angle can be detected with higher accuracy. This angle may be not less than 40 degrees and not more than 50 degrees.

Even in vibrations caused by the fifth electrode 35, sixth electrode 36, seventh electrode 37, and eighth electrode 38, vibration modes at high frequencies are suppressed. A wide band is possible with a simple configuration.

In a second operation, the controller 70 is configured to apply a second AC signal Sg2 between the fifth electrode 35 and the movable portion 10M, between the sixth electrode 36 and the movable portion 10M, between the seventh electrode 37 and the movable portion 10M, and between the eighth electrode 38 and the movable portion 10M. The second AC signal Sg2 causes the movable portion 10M to vibrate.

As shown in FIG. 1A, the element portion 10E may further include a fifth detection electrode 45, a sixth detection electrode 46, a seventh detection electrode 47, and an eighth detection electrode 48. The fifth detection electrode 45 is fixed to the base face 10fa and faces the movable portion 10M. The sixth detection electrode 46 is fixed to the base face 10fa and faces the movable portion 10M. The seventh detection electrode 47 is fixed to the base face 10fa and faces the movable portion 10M. The eighth detection electrode 48 is fixed to the base face 10fa and faces the movable portion 10M.

In this example, the fifth detection electrode 45, the sixth detection electrode 46, the seventh detection electrode 47, and the eighth detection electrode 48 face the second annular portion 12.

A direction from the fifth detection electrode 45 to the sixth detection electrode 46 (third detection direction) crosses the direction from the seventh detection electrode 47 to the eighth detection electrode 48 (fourth detection direction). The third detection direction is, for example, along the third direction D3. The fourth detection direction is along the fourth direction D4.

The controller 70 may be configured to detect the angular velocity acting on the element portion 10E based on information including the above-mentioned first to fourth detection signals, a fifth detection signal obtained between the fifth detection electrode 45 and the movable portion 10M, a sixth detection signal obtained between the sixth detection electrode 46 and the movable portion 10M, a seventh detection signal obtained between the seventh detection electrode 47 and the movable portion 10M, and an eighth detection signal obtained between the eighth detection electrode 48 and the movable portion 10M.

In the embodiment, the first detection electrode 41, the second detection electrode 42, the third detection electrode 43, and the fourth detection electrode 44 may be on the outside or inside with respect to the movable portion 10M (e.g., the second annular portion 12) to which the first detection electrode 41, the second detection electrode 42, the third detection electrode 43, and the fourth detection electrode 44 face.

In the embodiment, the fifth detection electrode 45, the sixth detection electrode 46, the seventh detection electrode 47, and the eighth detection electrode 48 may be on the outside or inside with respect to the movable portion 10M (e.g., the second annular portion 12) to which the fifth detection electrode 45, the sixth detection electrode 46, the seventh detection electrode 47, and the eighth detection electrode 48 face.

As already explained, the movable portion 10M may further include the third annular portion 13. The third annular portion 13 is concentric with the first annular portion 11, centered on the fixed portion center 10C in the first plane PL1 of the fixed portion 10F. In this example, the third annular portion 13 is located between the fixed portion 10F and the first annular portion 11.

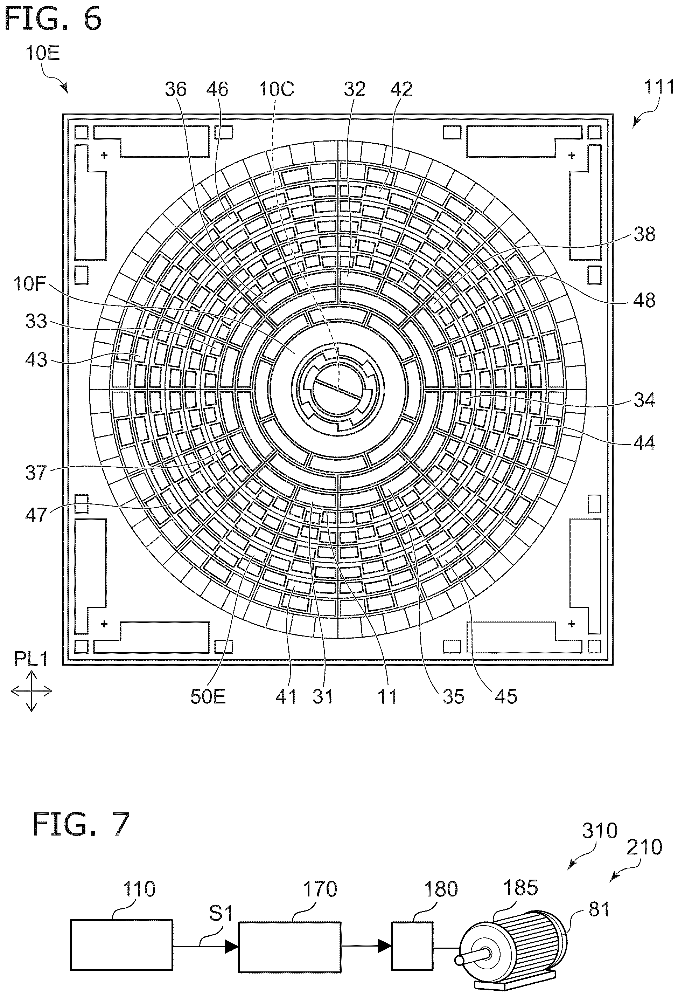

FIG. 6 is a schematic plan view illustrating a sensor according to the first embodiment.

As shown in FIG. 6, in a sensor 111 according to the embodiment, the element portion 10E may further include another electrode 50E, etc. The electrode 50E may be used for adjustment.

### (Second Embodiment)

The second embodiment relates to an electronic device.

FIG. 7 is a schematic diagram illustrating an electronic device according to a second embodiment.

As shown in FIG. , an electronic device 310 according to the embodiment includes the sensor according to the first embodiment and a circuit controller 170. In the example of FIG. 7, the sensor 110 is illustrated as the sensor. The circuit controller 170 is configured to control a circuit 180 based on a detected signal S0 obtained from the sensor. The circuit 180 is, for example, a control circuit of a driving device 185 or the like. According to the embodiment, for example, the circuit 180 for controlling the driving device 185 can be controlled with high accuracy.

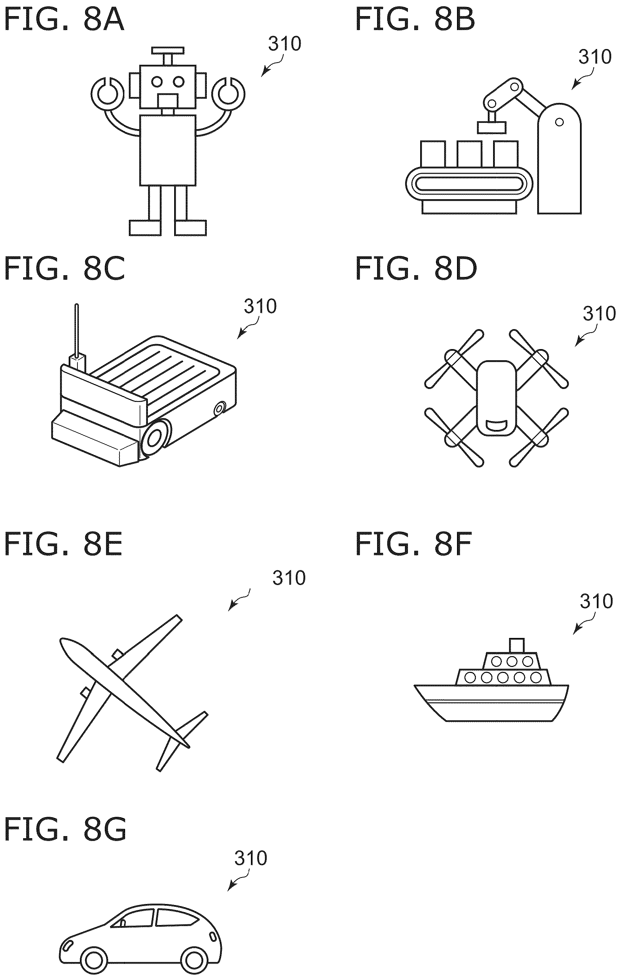

FIGS. 8A to 8G are schematic diagrams illustrating applications of the electronic device according to the embodiment.

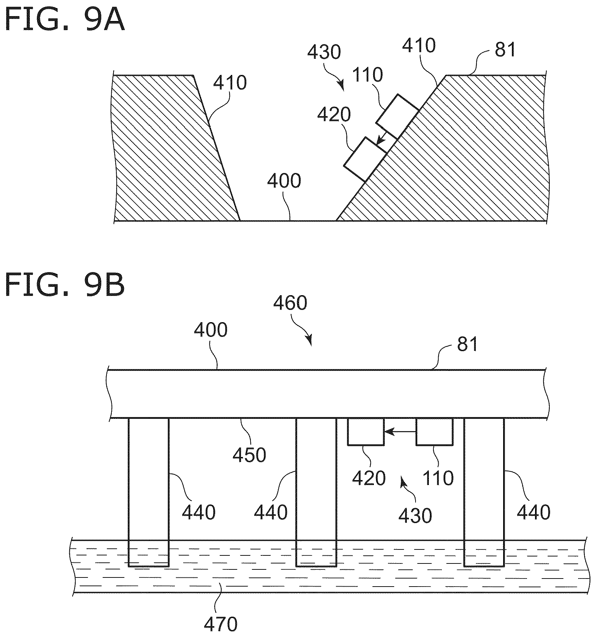

As shown in FIG. 9A, the electronic device 310 may be at least a part of a robot. As shown in FIG. 8B, the electronic device 310 may be at least a part of a work robot provided in a manufacturing factory or the like. As shown in FIG. 8C, the electronic device 310 may be at least a part of an automated guided vehicle such as in a factory. As shown in FIG. 8D, the electronic device 310 may be at least a part of a drone (unmanned aerial vehicle). As shown in FIG. 8E, the electronic device 310 may be at least a part of an airplane. As shown in FIG. 8F, the electronic device 310 may be at least a part of a vessel. As shown in FIG. 8G, the electronic device 310 may be at least a part of an automobile. The electronic device 310 may include, for example, at least one of a robot or a mobile object.

FIGS. 9A and 9B are schematic diagrams illustrating applications of the sensor according to the embodiment.

As shown in FIG. 9A, a sensor 430 according to the embodiment includes the sensor according to the first embodiment and a transmitter/receiver 420. In the example of FIG. 9A, the sensor 110 is drawn as the sensor. The transmitter/receiver 420 is configured to transmit the signal obtained from the sensor 110 by at least one of wireless or wired methods, for example. The sensor 430 is provided, for example, on a slope surface 410 such as a road 400. The sensor 430 may, for example, monitor conditions such as facilities (e.g., infrastructure). The sensor 430 may be, for example, a condition monitoring device.

For example, the sensor 430 detects changes in the state of the slope surface 410 of the road 400 with high accuracy. A change in the state of the slope surface 410 includes, for example, at least one of a change in tilt angle or a change in vibration state. The signal (test result) obtained from the sensor 110 is transmitted by the transmitter/receiver 420. The condition of facilities (e.g., infrastructure) can be monitored, e.g., continuously.

As shown in FIG. 9B, the sensor 430 is provided on a part of a bridge 460, for example. The bridge 460 is provided over a river 470. For example, the bridge 460 includes at least one of main girder 450 and a bridge pier 440. The sensor 430 is provided on at least one of the main girder 450 and the bridge pier 440. For example, the angle of at least one of the main girder 450 and the bridge pier 440 may change due to deterioration or the like. For example, in at least one of the main girder 450 and the bridge pier 440, the vibration state may change. The sensor 430 detects these changes with high accuracy. A detection result can be transmitted to an arbitrary place by the transmitter/receiver 420. Anomalies can be effectively detected.

The embodiments include the following Technical proposals:

### (Technical proposal 1)

A sensor, comprising:
an element portion,
the element portion including:
   a base including a base face;
   a fixed portion fixed to the base face;
   a movable portion supported by the fixed portion, a gap being provided between the base face and the movable portion, the movable portion including a first annular portion provided around the fixed portion in a first plane along the base face, the first annular portion including a first partial region, a second partial region, a third partial region, and a fourth partial region;
   a first electrode fixed to the base face and facing the first partial region;
   a second electrode fixed to the base face and facing the second partial region;
   a third electrode fixed to the base face and facing the third partial region; and
   a fourth electrode fixed to the base face and facing the fourth partial region,
a first direction from the first electrode to the second electrode crossing a second direction from the third electrode to the fourth electrode,
the first partial region being between the first electrode and the fixed portion in the first direction,
the second partial region being between the fixed portion and the second electrode in the first direction,
the third electrode being between the third partial region and the fixed portion in the second direction,
the fourth electrode being between the fixed portion and the fourth partial region in the second direction,
the first electrode, the second electrode, the third electrode, and the fourth electrode being configured to be input with a first signal.

### (Technical proposal 2)

The sensor according to Technical proposal 1, wherein
a first angle between the first direction and the second direction is 90 degrees.

### (Technical proposal 3)

The sensor according to Technical proposal 2, further comprising:
a controller,
the controller being configured to apply a first AC signal between the first electrode and the movable portion, between the second electrode and the movable portion, between the third electrode and the movable portion, and between the fourth electrode and the movable portion in a first operation.

### (Technical proposal 4)

The sensor according to Technical proposal 3, wherein
when a first distance between the first partial region and the second partial region increases, a second distance between the third partial region and the fourth partial region decreases, and
when the first distance decreases, the second distance increases.

### (Technical proposal 5)

The sensor according to Technical proposal 3, wherein
a vibration state of the first annular portion changes according to an angular velocity applied to the element part.

### (Technical proposal 6)

The sensor according to Technical proposal 3, wherein
the element portion further includes:
a first detection electrode fixed to the base face and facing the movable portion;
a second detection electrode fixed to the base face and facing the movable portion;
a third detection electrode fixed to the base face and facing the movable portion; and
a fourth detection electrode fixed to the base face and facing the movable portion,
a first detection direction from the first detection electrode to the second detection electrode crosses a second detection direction from the third detection electrode to the fourth detection electrode.

### (Technical proposal 7)

The sensor according to Technical proposal 6, wherein
the first detection direction is along the first direction, and
the second detection direction is along the second direction.

### (Technical proposal 8)

The sensor according to Technical proposal 7, wherein
the controller is configured to detect an angular velocity acting on the element portion based on information including:
a first detection signal obtained between the first detection electrode and the movable portion;
a second detection signal obtained between the second detection electrode and the movable portion;
a third detection signal obtained between the third detection electrode and the movable portion; and
a fourth detection signal obtained between the fourth detection electrode and the movable portion.

### (Technical proposal 9)

The sensor according to any one of Technical proposals 6-8, wherein
the movable portion further includes a second annular portion,
the second annular portion is concentric with the first annular portion around the center of the fixed portion in the first plane of the fixed portion, and
the first detection electrode, the second detection electrode, the third detection electrode, and the fourth detection electrode face the second annular portion.

### (Technical proposal 10)

The sensor according to Technical proposal 6, wherein
the first annular portion includes a fifth partial region, a sixth partial region, a seventh partial region, and an eighth partial region,
the element portion includes:
   a fifth electrode fixed to the base face and facing the fifth partial region;
   a sixth electrode fixed to the base face and facing the sixth partial region;
   a seventh electrode fixed to the base face and facing the seventh partial region; and
   an eighth electrode fixed to the base face and facing the eighth partial region,
a third direction from the fifth electrode to the sixth electrode crosses a fourth direction from the seventh electrode to the eighth electrode,
the third direction is inclined with respect to the first direction,
the fifth partial region is between the fifth electrode and the fixed portion in the third direction,
the sixth partial region is between the fixed portion and the sixth electrode in the third direction,
the seventh electrode is between the seventh partial region and the fixed portion in the fourth direction,
the eighth electrode is between the fixed portion and the eighth partial region in the fourth direction, and
the fifth electrode, the sixth electrode, the seventh electrode and the eighth electrode are configured to be input with a second signal.

### (Technical proposal 11)

The sensor according to Technical proposal 10, wherein
the second angle between the third direction and the fourth direction is 90 degrees.

### (Technical proposal 12)

The sensor according to Technical proposal 11, wherein
the angle between the third direction and the first direction is 45 degrees.

### (Technical proposal 13)

The sensor according to any one of Technical proposals 10-12, wherein
the controller is configured to apply a second AC signal between the fifth electrode and the movable portion, between the sixth electrode and the movable portion, between the seventh electrode and the movable portion, and between the eighth electrode and the movable portion in a second operation.

### (Technical proposal 14)

The sensor according to Technical proposal 13, wherein
the element portion further includes:
   a fifth detection electrode fixed to the base face and facing the movable portion;
   a sixth detection electrode fixed to the base face and facing the movable portion;
   a seventh detection electrode fixed to the base face and facing the movable portion; and
   an eighth detection electrode fixed to the base face and facing the movable portion, and
a third detection direction from the fifth detection electrode to the sixth detection electrode crosses a fourth detection direction from the seventh detection electrode to the eighth detection electrode.

### (Technical proposal 15)

The sensor according to Technical proposal 14, wherein
the third detection direction is along the third direction, and
the fourth detection direction is along the fourth direction.

### (Technical proposal 16)

The sensor according to Technical proposal 15, wherein
the controller is configured to detect an angular velocity acting on the element portion based on information including:
a first detection signal obtained between the first detection electrode and the movable portion;
a second detection signal obtained between the second detection electrode and the movable portion;
a third detection signal obtained between the third detection electrode and the movable portion;
a fourth detection signal obtained between the fourth detection electrode and the movable portion;
a fifth detection signal obtained between the fifth detection electrode and the movable portion;
a sixth detection signal obtained between the sixth detection electrode and the movable portion;
a seventh detection signal obtained between the seventh detection electrode and the movable portion; and
an eighth detection signal obtained between the eighth detection electrode and the movable portion.

### (Technical proposal 17)

The sensor according to any one of Technical proposals 14-16, wherein
the movable portion further includes a second annular portion,
the second annular portion is concentric with the first annular portion around the center of the fixed portion in the first plane of the fixed portion, and
the fifth detection electrode, the sixth detection electrode, the seventh detection electrode, and the eighth detection electrode face the second annular portion.

### (Technical proposal 18)

The sensor according to Technical proposal 6, wherein
the first detection electrode, the second detection electrode, the third detection electrode, and the fourth detection electrode are on outside or inside with respect to the movable portion to which the first detection electrode, the second detection electrode, the third detection electrode, and the fourth detection electrode face.

### (Technical proposal 19)

The sensor according to any one of Technical proposals 1-6, wherein
the fixed portion includes a fixed portion center on the base face,
the movable portion includes a radiating portion connected to the fixed portion,
the radiating portion extends along a radial direction,
the radial direction passes through the fixed portion center and is along the base face, and
the first annular portion is connected to the radiating portion.

### (Technical proposal 20)

An electronic device comprising:
the sensor according to any one of Technical proposals 1-19; and
a circuit controller configures to control a circuit based on a signal obtained from the sensor.

According to the embodiment, it is possible to provide sensors and electronic devices that can improve the characteristics.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in sensors such as sensor portions, bases, fixing portions, movable portions, electrodes, controllers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all sensors and all electronic devices practicable by an appropriate design modification by one skilled in the art based on the sensors and the electronic devices described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A sensor, comprising:
an element portion,
the element portion including:
a base including a base face;
a fixed portion fixed to the base face;
a movable portion supported by the fixed portion, a gap being provided between the base face and the movable portion, the movable portion including a first annular portion provided around the fixed portion in a first plane along the base face, the first annular portion including a first partial region, a second partial region, a third partial region, and a fourth partial region;
a first electrode fixed to the base face and facing the first partial region;
a second electrode fixed to the base face and facing the second partial region;
a third electrode fixed to the base face and facing the third partial region; and
a fourth electrode fixed to the base face and facing the fourth partial region,
a first direction from the first electrode to the second electrode crossing a second direction from the third electrode to the fourth electrode,
the first partial region being between the first electrode and the fixed portion in the first direction,
the second partial region being between the fixed portion and the second electrode in the first direction,
the third electrode being between the third partial region and the fixed portion in the second direction,
the fourth electrode being between the fixed portion and the fourth partial region in the second direction,
the first electrode, the second electrode, the third electrode, and the fourth electrode being configured to be input with a first signal.

2. The sensor according to claim 1, wherein
a first angle between the first direction and the second direction is 90 degrees.

3. The sensor according to claim 2, further comprising:
a controller,
the controller being configured to apply a first AC signal between the first electrode and the movable portion, between the second electrode and the movable portion, between the third electrode and the movable portion, and between the fourth electrode and the movable portion in a first operation.

4. The sensor according to claim 3, wherein
when a first distance between the first partial region and the second partial region increases, a second distance between the third partial region and the fourth partial region decreases, and
when the first distance decreases, the second distance increases.

5. The sensor according to claim 3, wherein
a vibration state of the first annular portion changes according to an angular velocity applied to the element part.

6. The sensor according to claim 3, wherein
the element portion further includes:
a first detection electrode fixed to the base face and facing the movable portion;
a second detection electrode fixed to the base face and facing the movable portion;
a third detection electrode fixed to the base face and facing the movable portion; and
a fourth detection electrode fixed to the base face and facing the movable portion,
a first detection direction from the first detection electrode to the second detection electrode crosses a second detection direction from the third detection electrode to the fourth detection electrode.

7. The sensor according to claim 6, wherein
the first detection direction is along the first direction, and
the second detection direction is along the second direction.

8. The sensor according to claim 7, wherein
the controller is configured to detect an angular velocity acting on the element portion based on information including:
a first detection signal obtained between the first detection electrode and the movable portion;
a second detection signal obtained between the second detection electrode and the movable portion;
a third detection signal obtained between the third detection electrode and the movable portion; and
a fourth detection signal obtained between the fourth detection electrode and the movable portion.

9. The sensor according to any one of claims 6-8, wherein
the movable portion further includes a second annular portion,
the second annular portion is concentric with the first annular portion around the center of the fixed portion in the first plane of the fixed portion, and
the first detection electrode, the second detection electrode, the third detection electrode, and the fourth detection electrode face the second annular portion.

10. The sensor according to claim 6, wherein
the first annular portion includes a fifth partial region, a sixth partial region, a seventh partial region, and an eighth partial region,
the element portion includes:
a fifth electrode fixed to the base face and facing the fifth partial region;
a sixth electrode fixed to the base face and facing the sixth partial region;
a seventh electrode fixed to the base face and facing the seventh partial region; and
an eighth electrode fixed to the base face and facing the eighth partial region,
a third direction from the fifth electrode to the sixth electrode crosses a fourth direction from the seventh electrode to the eighth electrode,
the third direction is inclined with respect to the first direction,
the fifth partial region is between the fifth electrode and the fixed portion in the third direction,
the sixth partial region is between the fixed portion and the sixth electrode in the third direction,
the seventh electrode is between the seventh partial region and the fixed portion in the fourth direction,
the eighth electrode is between the fixed portion and the eighth partial region in the fourth direction, and
the fifth electrode, the sixth electrode, the seventh electrode and the eighth electrode are configured to be input with a second signal.

11. The sensor according to claim 10, wherein
the second angle between the third direction and the fourth direction is 90 degrees.

12. The sensor according to claim 11, wherein
the angle between the third direction and the first direction is 45 degrees.

13. The sensor according to any one of claims 10-12, wherein
the controller is configured to apply a second AC signal between the fifth electrode and the movable portion, between the sixth electrode and the movable portion, between the seventh electrode and the movable portion, and between the eighth electrode and the movable portion in a second operation.

14. The sensor according to any one of claims 1-6, wherein
the fixed portion includes a fixed portion center on the base face,
the movable portion includes a radiating portion connected to the fixed portion,
the radiating portion extends along a radial direction,
the radial direction passes through the fixed portion center and is along the base face, and
the first annular portion is connected to the radiating portion.

15. An electronic device comprising:
the sensor according to any one of claims 1-14; and
a circuit controller configures to control a circuit based on a signal obtained from the sensor.
